# EUROPÄISCHE PATENTANMELDUNG

(11) **EP 3 910 348 A1**
(43) Veröffentlichungstag der Anmeldung: **17.11.2021**
(21) Anmeldenummer: 21169227.2
(22) Anmeldetag: 19.04.2021
(51) Int. Cl.: G01R 19/155, G01R 15/16

(54) **KAPAZITIVER SPANNUNGSPRÜFER**

(30) Priorität: 27.04.2020 DE 102020111411
(71) Anmelder: Arcus Elektrotechnik Alois Schiffmann GmbH, 81673 München (DE)
(72) Erfinder: KOZLOV, Valentin, 81377 München (DE); HANUSCH, Andreas, 85586 Poing (DE); RENZ, Marion, 80337 München (DE)
(74) Vertreter: Sajda, Wolf E.

(57) **Zusammenfassung**

Die Erfindung betrifft einen kapazitiven Spannungsprüfer (1), wobei der Spannungsprüfer (1) eine Kontaktelektrode (2) aufweist, welche dazu ausgebildet ist, bedarfsweise mit der zu prüfenden elektrischen Leitung (100) einen galvanischen Kontakt auszubilden. Der Spannungsprüfer (1) weist ferner eine Prüfeinrichtung (3) mit einer in einem Messbereich (4) angeordneten Sensoreinrichtung (7.1, 7.2) zum Erfassen eines elektrischen Felds in dem Messbereich (4) auf. Ferner weist der Spannungsdetektor (1) eine mit der Sensoreinrichtung (7.1, 7.2) signaltechnisch und insbesondere galvanisch verbundene Auswerteelektronik (5) auf. Erfindungsgemäß weist die Prüfeinrichtung (3) eine Abschirmeinrichtung (6) auf, welche dazu ausgebildet ist, in Abhängigkeit von einer an der zu prüfenden elektrischen Leitung (100) anliegenden Nennspannung in dem Messbereich (4) ein von der Sensoreinrichtung (7.1, 7.2) als Messfeld zu erfassendes homogenes elektrisches Feld zu generieren, und welche ferner ausgebildet ist, das Messfeld vor externen Störfeldern abzuschirmen.

## Beschreibung

Die vorliegende Erfindung betrifft allgemein Spannungsprüfer und insbesondere tragbare Spannungsprüfer mit eingebauter oder ohne eingebaute Energiequelle zur Verwendung in elektrischen Netzen mit Wechselspannungen von 1 kV bis 765 kV und Frequenzen von 50 Hz und/oder 60 Hz und/oder Frequenzen von 25 Hz und 16,7 Hz (z.B. bei Bahnstromnetzen).

Die Erfindung betrifft insbesondere kapazitive Spannungsprüfer, die bei der Anwendung mit den zu prüfenden Anlageteilen Kontakt haben.

Unter dem hier verwendeten Begriff "Spannungsprüfer" ist allgemein ein tragbares Gerät zum einwandfreien Feststellen des Vorhandenseins oder Nichtvorhandenseins von Betriebsspannungen (AC oder DC, Hoch- oder Niederspannung) zu verstehen, welches zum Nachweis verwendet wird, dass eine Anlage geerdet werden kann. Obgleich derartige Geräte auch ohmsch ausgeführt sein können, betrifft die vorliegende Erfindung insbesondere kapazitiv ausgeführte Spannungs-prüfer, also Geräte, deren Funktion auf dem Strom durch die Streukapazität zur Erde beruht.

In Energieverteilnetzen mit Hochspannung wird im Allgemeinen der Betriebszustand der Anlagen über das Vorhandensein oder Nichtvorhandensein der Betriebsspannung festgestellt. Das Feststellen des Spannungszustands wird mittels Mess- oder Prüfsystemen, insbesondere mit Spannungsprüfern vorge-nommen. Technisch wird über einen kapazitiven Spannungsteiler eine Mess-spannung mit deutlich geringerer Amplitude erzeugt und mit Hilfe eines optischen und/oder akustischen Anzeigegeräts der Zustand "Spannung vorhanden" angezeigt.

Spannungsfreiheit ist die Voraussetzung zum Erden freigeschalteter Anlagenteile und damit zum Arbeiten in einer Hochspannungs-Anlage oder an einer Hochspannungs-Leitung bzw. einem Hochspannungs-Kabel. Die Spannungsfreiheit wird in Wechselspannungsanlagen über 1 kV Betriebsspannung beispielsweise mittels einpoligen kapazitiven Spannungsprüfern festgestellt, deren Bauform und Funktion beispielsweise in den Normen IEC61243-1 oder DIN VDE V0682-421 oder in VDE0681-6 festgelegt ist.

Kapazitive Spannungsprüfer der hier berücksichtigten Art sind allgemein aus dem Stand der Technik bekannt. Beispielsweise betrifft die Druckschrift DE 10 2005 001 179 A1 einen kapazitiven Spannungsprüfer, der eine Kontaktelektrode, eine metallische Masse, welche Gegengewicht genannt wird, einen Last- bzw. Ladewiderstand, eine Detektionsschaltung und ein Signal- bzw. Signalisierungselement aufweist. Die Kontaktelektrode ist direkt mit einer ersten Klemme des Ladewiderstands verbunden, wobei eine zweite Klemme mit dem Gegengewicht verbunden ist. Die Detektionsschaltung ist mit Klemmen bzw. Kontakten des Ladewiderstands verbunden und steuert das Anzeige- bzw. Signalisierelement.

Um eine negative Beeinflussung der Funktionsfähigkeit des aus diesem Stand der Technik bekannten Spannungsprüfers durch Störfelder zu reduzieren oder zu vermeiden, kommt bei der aus der Druckschrift DE 10 2005 001 179 A1 bekannten Vorrichtung ein Faradayscher Käfig zum Einsatz, in welchem der Ladewiderstand und die Detektionsschaltung aufgenommen und entsprechend geschützt sind.

Unter einem Faradayschen Käfig ist eine allseitig geschlossene Hülle aus einem elektrischen Leiter (z.B. Drahtgeflecht oder Blech) zu verstehen, die als elektrische Abschirmung wirkt. Bei äußeren statischen oder quasi-statischen elektrischen Feldern, insbesondere Störfeldern, bleibt der innere Bereich des Faradayschen Käfigs in Folge der Influenz feldfrei. Daher kann durch das Vorsehen eines entsprechenden Faradayschen Käfigs die Detektionsschaltung vor Störeinflüssen geschützt werden.

Die Abschirmwirkung eines Faradayschen Käfigs ist jedoch nicht bei zeitlich veränderlichen Vorgängen, wie elektromagnetischen Wellen gegeben. Darüber hinaus weist die aus der Druckschrift DE 10 2005 001 179 A1 bekannte Lösung den Nachteil auf, dass durch das Vorsehen der allseitig geschlossenen Hülle aus einem elektrischen Leiter, die den Faradayschen Käfig ausbildet, die Baugröße des Spannungsdetektors und insbesondere das Gewicht des Spannungsdetektors erhöht werden.

Demnach ist es wünschenswert, einen kapazitiven Spannungsdetektor anzugeben, der trotz reduziertem Gewicht und geringerer Baugröße möglichst optimal gegenüber Störfeldern geschützt ist.

Unter dem hier verwendeten Begriff "Störfeld" ist ein überlagerndes elektrisches Feld zu verstehen, das die Anzeige des Spannungsdetektors beeinflussen kann. Ein gleichphasiges Störfeld liegt vor, wenn eine kleine Potenzialänderung in Richtung der Spannungsdetektorachse eine Fehlanzeige erzeugt. Dies ergibt sich in Folge der räumlichen Ausdehnung und/oder der Konfiguration des zu prüfen-den Anlageteils oder benachbarter Anlageteile mit Spannungen gleicher Phasenlage.

Ein gegenphasiges Störfeld liegt vor, wenn eine große Potenzialänderung in Richtung der Spannungsdetektorachse eine Fehlanzeige erzeugt. Dies ergibt sich in Folge benachbarter Anlageteile mit gegenphasigen Spannungen.

Zur Lösung der der Erfindung zu Grunde liegenden Aufgabe wird erfindungsgemäß ein kapazitiver Spannungsprüfer, insbesondere für eine oberirdische elektrische Leitung vorgeschlagen, wobei der Spannungsprüfer eine Kontaktelektrode aufweist, welche ausgebildet ist, bedarfsweise mit der zu prüfenden elektrischen Leitung einen galvanischen Kontakt auszubilden.

Der Spannungsprüfer weist ferner eine Prüfeinrichtung mit einer in einem Messbereich angeordneten Sensoreinrichtung auf zum Erfassen eines elektrischen Felds in dem Messbereich. Ferner weist der Spannungsprüfer eine mit der Sensoreinrichtung signaltechnisch verbundene Auswerteelektronik auf.

Um die in dem Messbereich angeordnete Sensoreinrichtung wirkungsvoll gegen Störfelder abzuschirmen, ohne dass hierzu ein Faradayscher Käfig zum Einsatz kommt, ist erfindungsgemäß vorgesehen, dass die Prüfeinrichtung eine Abschirmeinrichtung aufweist, welche einerseits dazu ausgebildet ist, in Abhängigkeit von einer an der zu prüfenden elektrischen Leitung anliegenden Nennspannung in dem Messbereich ein von der Sensoreinrichtung als Messfeld zu erfassendes homogenes elektrisches Feld zu generieren, und welche andererseits (zusätzlich) dazu ausgebildet ist, das Messfeld gegenüber externen Störfeldern abzuschirmen.

Gemäß bevorzugten Realisierungen des erfindungsgemäßen Spannungsprüfers weist die Abschirmeinrichtung eine erste Elektrode (Schirmelektrode) und eine von der ersten Elektrode beabstandete zweite Elektrode (Referenzelektrode) auf. Dabei ist der Messbereich in einem Bereich zwischen der ersten und zweiten Elektrode ausgebildet. Die erste Elektrode ist über die Kontaktelektrode signaltechnisch mit der zu prüfenden elektrischen Leitung verbunden oder verbindbar. Hingegen ist die zweite Elektrode mit einem Referenzpotenzial, insbesondere mit dem Erdpotenzial, signaltechnisch (beispielsweise kapazitiv oder galvanisch) verbunden oder verbindbar.

Als eine "signaltechnische Verbindung" ist hierbei jedwede Verbindung zu verstehen, über welche Messsignale oder auszuwertende Signale übertragbar sind. Hierunter fallen insbesondere kapazitive, induktive und/oder galvanische Verbindungen.

Das Funktionsprinzip des erfindungsgemäßen Spannungsprüfers beruht auf der Messung der Spannung in dem homogenen elektrischen Messfeld zwischen der ersten Elektrode und der zweiten Elektrode.

Gemäß Ausführungsformen des erfindungsgemäßen Spannungsprüfers weist die erste Elektrode eine mit Bezug auf eine senkrechte Ausrichtung zu den Feldlinien des Messfelds ausgerichtete Elektrodenfläche mit einem ersten insbesondere effektiven Durchmesser auf. Ferner weist die zweite Elektrode eine mit Bezug auf eine senkrechte Ausrichtung zu den Feldlinien des Messfelds ausgerichtete Elektrodenfläche mit einem zweiten, insbesondere effektiven Durchmesser auf.

Vorzugsweise ist dabei der erste Durchmesser zumindest im Wesentlichen gleich groß wie der zweite Durchmesser.

Alternativ oder zusätzlich hierzu ist es bevorzugt, dass die Elektrodenfläche der ersten Elektrode der Abschirmeinrichtung und die Elektrodenfläche der zweiten Elektrode der Abschirmeinrichtung zumindest im Wesentlichen die gleiche Formgebung aufweisen.

Gemäß bevorzugten Realisierungen des erfindungsgemäßen Spannungsprüfers ist in diesem Zusammenhang vorgesehen, dass die Elektrodenfläche der ersten Elektrode der Abschirmeinrichtung und/oder die Elektrodenfläche der zweiten Elektrode der Abschirmeinrichtung die Form eines sogenannten Gleichdickes, und insbesondere die Form eines Reuleaux-Dreieckes aufweisen/aufweist. Selbstverständlich kommen aber auch andere Formgebungen in Frage.

Andererseits ist es bevorzugt, wenn der Abstand der Elektrodenfläche der ersten Elektrode der Abschirmeinrichtung von der Elektrodenfläche der zweiten Elektrode der Abschirmeinrichtung dem 0,3-fachen bis 0,7-fachen und vorzugsweise dem 0,4-fachen bis 0,6-fachen und noch bevorzugter etwa dem 0,5-fachen des ersten und/oder zweiten Durchmessers der Elektrodenfläche der ersten und/oder zweiten Elektrode der Abschirmeinrichtung entspricht. Mit einer solchen Dimensionierung ist eine optimale Abschirmung des Messfeldes gegenüber Störfeldern realisierbar, ohne dass hierzu ein Faraday scher Käfig benötigt wird.

Gemäß bevorzugten Realisierungen des erfindungsgemäßen Spannungsprüfers ist in diesem Zusammenhang vorgesehen, dass der Abstand der Elektrodenfläche der ersten Elektrode der Abschirmeinrichtung von der Elektrodenfläche der zweiten Elektrode der Abschirmeinrichtung 10 mm bis 100 mm und vorzugsweise 20 mm bis 80 mm und noch bevorzugter 30 mm bis 70 mm beträgt.

Insbesondere bei bevorzugten Ausführungsformen erfindungsgemäßen Spannungsprüfers ist vorgesehen, dass die zweite Elektrode der Abschirmeinrichtung eine in Richtung der ersten Elektrode der Abschirmeinrichtung ausgerichtete erste Fläche und eine gegenüberliegende zweite Fläche aufweist, wobei die Auswerteelektronik zumindest bereichsweise hinter der zweiten Fläche der zweiten Elektrode der Abschirmeinrichtung angeordnet ist.

Durch diese Anordnung der Auswerteelektronik ist sichergestellt, dass auch ohne das Vorsehen eines Faradayschen Käfigs die Auswerteelektronik gegenüber externen Störfeldern optimal geschützt ist.

Vorzugsweise weist die Auswerteelektronik einen Mikrocontroller mit einem Operationsverstärker, einem Komparator und einem D/A-Wandler auf und ist dazu ausgebildet, einen von dem mindestens einen Feldsensor in dem Messfeld erfassten Potenzialunterschied auszuwerten.

Insbesondere weist der Spannungsprüfer ein Anzeigegerät auf, welches von der Auswerteelektronik ansteuerbar und dazu ausgebildet ist, in Abhängigkeit von dem von dem mindestens einen Feldsensor in dem Messfeld erfassten Potenzialunterschied das Vorhandensein oder das Nichtvorhandensein von Betriebsspannung an der Kontaktelektrode anzuzeigen.

Unter dem hier verwendeten Begriff "Anzeigegerät" ist ein Teil des Spannungsprüfers zu verstehen, der das Vorhandensein oder das Nichtvorhandensein von Betriebsspannung an der Kontaktelektrode anzeigt. Um das Vorhandensein oder das Nichtvorhandensein von Betriebsspannung an der Kontaktelektrode anzuzeigen, kann das Anzeigegerät mindestens eine optische und/oder akustische Schnittstelleneinrichtung aufweisen.

Vorzugsweise weist die in dem Messbereich angeordnete Sensoreinrichtung einen ersten Feldsensor und optional zusätzlich einen in Richtung der Feldlinien des elektrischen Felds von dem ersten Feldsensor beabstandeten, zweiten Feldsensor auf und ist insbesondere dazu ausgebildet, mit Hilfe des mindestens einen Feldsensors einen Potenzialunterschied in dem elektrischen Feld zu erfassen.

Gemäß bevorzugten Realisierungen des erfindungsgemäßen Spannungsprüfers ist vorgesehen, dass der mindestens eine Feldsensor eine vorzugsweise abgerundete oder runde Feldsonde mit einem Radius von 4 mm bis 15 mm und vorzugsweise mit einem Radius von 6 mm bis 13 mm und noch bevorzugter mit einem Radius von etwa 8 mm bis 11 mm aufweist, wobei der Abstand der Elektrodenfläche der ersten Elektrode von der Elektrodenfläche der zweiten Elektrode 30 mm bis 80 mm und vorzugsweise 40 mm bis 70 mm beträgt.

Mit diesen Dimensionen ist einerseits ein besonders kompakter Aufbau des Spannungsprüfers realisierbar, wobei zugleich die Störanfälligkeit gegenüber externen Einwirkungen maximal reduziert ist.

Gemäß Weiterbildungen der zuletzt genannten Ausführungsformen des erfindungsgemäßen Spannungsprüfers ist vorgesehen, dass zumindest bereichsweise zwischen der ersten Elektrode der Abschirmeinrichtung und der zweiten Elektrode der Abschirmeinrichtung der Messbereich gebildet ist, wobei die Sensoreinrichtung einen zumindest bereichsweise in dem Messbereich angeordneten ersten Feldsensor und optional einen in Richtung der Feldlinien des elektrischen Felds von dem ersten Feldsensor beabstandeten und zumindest bereichsweise in dem Messbereich angeordneten zweiten Feldsensor aufweist.

Die Sensoreinrichtung und insbesondere der zumindest bereichsweise in dem Messbereich angeordnete erste Feldsensor der Sensoreinrichtung ist vorzugsweise dazu ausgebildet, einen Potenzialunterschied in dem elektrischen Feld in dem Messbereich zu erfassen.

In diesem Zusammenhang bietet es sich an, dass in dem Messbereich der erste Feldsensor der Sensoreinrichtung an oder in unmittelbarer Nähe der ersten Elektrode der Abschirmeinrichtung oder der zweiten Elektrode der Abschirmeinrichtung angeordnet ist, wobei der Abstand zwischen einem Sensorbereich des ersten Feldsensors der Sensoreinrichtung und der ersten Elektrode der Abschirmeinrichtung oder der zweiten Elektrode der Abschirmeinrichtung vorzugsweise maximal 5 mm und vorzugsweise insbesondere maximal 2 mm beträgt.

Gemäß Realisierungen des erfindungsgemäßen Spannungsprüfers ist vorgesehen, dass die Abschirmeinrichtung eine erste Elektrode und eine von der ersten Elektrode beabstandete, zweite Elektrode aufweist, wobei die Elektrodenfläche der ersten Elektrode und die Elektrodenfläche der zweiten Elektrode vorzugsweise zumindest im Wesentlichen die gleiche Formgebung aufweisen.

Beispielsweise ist es in diesem Zusammenhang denkbar, dass die Elektrodenfläche der ersten Elektrode und/oder die Elektrodenfläche der zweiten Elektrode die Form eines Gleichdickes, und insbesondere die Form eines Reuleaux-Dreieckes aufweisen/aufweist. Selbstverständlich sind hier aber auch andere Formgebungen denkbar.

Gemäß Ausführungsformen des erfindungsgemäßen Spannungsprüfers ist die Kontaktelektrode vorzugsweise über eine Kontaktelektrodenverlängerung signaltechnisch mit der zu prüfenden elektrischen Leitung verbunden oder verbindbar, wobei die Kontaktelektrodenverlängerung mindestens eine vorab festgelegte oder festlegbare elektrische Impedanz aufweist.

Unter dem hier verwendeten Begriff "Kontaktelektrodenverlängerung" ist ein äußerlich isolierter, leitfähiger Teil zwischen einem Anzeigegerät des Spannungsprüfers und der Kontaktelektrode zu verstehen, um die richtige Stellung des Anzeigegeräts zum zu prüfenden Anlagenteil zu erreichen. Ein Anzeigegerät gemäß der vorliegenden Erfindung ist ein Teil des Spannungsprüfers, der das Vorhandensein oder Nichtvorhandensein von Betriebsspannung an der Kontaktelektrode anzeigt.

Andererseits ist unter dem Begriff "Kontaktelektrode" allgemein der nicht isolierte, leitfähige Teil am leitfähigen, die elektrische Verbindung zum zu prüfenden Anlageteil herstellenden Bauelement zu verstehen.

Gemäß bevorzugten Weiterbildungen des erfindungsgemäßen Spannungsprüfers weist dieser eine Eigenprüfvorrichtung auf, nämlich zum bedarfsweisen Prüfen der Funktion des Spannungsprüfers.

In diesem Zusammenhang ist es denkbar, dass die erste Elektrode und die von der ersten Elektrode beabstandete, zweite Elektrode der Abschirmeinrichtung einen Kondensator bilden, wobei die Eigenprüfvorrichtung dazu ausgebildet ist, die Kapazität des von der ersten und zweiten Elektrode gebildeten Kondensators zu messen.

Insbesondere ist die Eigenprüfvorrichtung dazu ausgebildet, vorzugsweise über eine Messung der Kapazität des von der ersten und zweiten Elektrode gebildeten Kondensators zu prüfen, einerseits ob ein durchgehender galvanischer Kontakt zwischen der Kontaktelektrode und dem Kondensator existiert und andererseits ob die Signal-Integrität gegeben ist und ein Signal auf dem Weg der Kontaktelektrode zu der Auswerteelektronik nicht verändert ist.

Nachfolgend werden unter Bezugnahme auf die beiliegenden Zeichnungen Ausführungsformen und weitere Aspekte der vorliegenden Erfindung näher beschrieben.

In den Zeichnungen zeigen:
- FIG. 1: schematisch das Funktionsprinzip und den Aufbau einer exemplarischen Ausführungsform des erfindungsgemäßen kapazitiven Spannungsprüfers;
- FIG. 2: schematisch und in einer teiltransparenten isometrischen Ansicht einen Bereich einer ersten exemplarischen Ausführungsform des erfindungsgemäßen kapazitiven Spannungsprüfers;
- FIG. 3: schematisch und in einer isometrischen Ansicht die Prüfeinrichtung des kapazitiven Spannungsprüfers gemäß FIG. 2;
- FIG. 4: schematisch und in einer teiltransparenten isometrischen Ansicht einen Bereich einer zweiten exemplarischen Ausführungsform des erfindungsgemäßen kapazitiven Spannungsprüfers; und
- FIG. 5: schematisch und in einer isometrischen Ansicht die Prüfeinrichtung des kapazitiven Spannungsprüfers gemäß FIG. 4.

Die vorliegende Erfindung betrifft einen Spannungsprüfer bzw. Spannungsprüfer für Prüfungen in Hochspannungs-Energieversorgungsnetzen, insbesondere für die Prüfung von Hochspannungsfreileitungen, wobei gemäß Ausführungsformen des erfindungsgemäßen Spannungsprüfers dieser einen Griff aufweist, der ein Gerätegehäuse trägt. In dem Gerätegehäuse ist ein Prüfgerät aufgenommen, welches auf der dem Griff abgekehrten Seite eine Kontaktelektrode und auf der dem Griff zugekehrten Seite ein Anzeigegerät aufweist.

Eine relativ weitgehende Unterdrückung von Störeinflüssen lässt sich mit solchen Spannungsprüfern erreichen, die an dem einen Ende einer Isolierstange eine Prüfelektrode aufweisen, welche mittels der Stange an den zu prüfenden Leiter herangeführt wird. Bei Prüfarbeiten in Hochspannungsnetzen müssen aber aus Sicherheitsgründen die Isolierstangen dieser Spannungsprüfer eine so große Länge haben, dass die Handhabung unter ungünstigen äußeren Bedingungen, beispielsweise dann, wenn die die Prüfung ausführende Person auf einer Traverse stehen muss, schwierig oder gar gefährlich sein kann.

Andererseits ist beispielsweise aus der Druckschrift DE 10 2005 001 179 B4 ein Spannungsprüfer bekannt, dessen Funktionsprinzip auf der Messung der Spannung mit Hilfe eines Kondensators beruht. Dieser Kondensator befindet sich zwischen dem zu prüfenden Leiter und einem Gegengewicht (metallische Masse) im Spannungsprüfer. Das Gegengewicht ist mit dem Erdpotenzial verbunden. Dabei bildet sich eine parasitäre Kapazität, die einen Stromfluss über den Ladewiderstand des Spannungsprüfers erlaubt.

Um den Ladewiderstand und die Elektronik vor Störfeldern zu schützen, wird sie von einem Faradayschen Käfig umgeben.

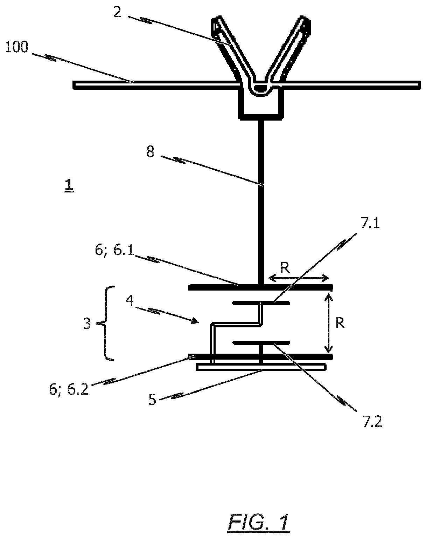

Mit dem Ziel, zur Prüfung der Spannung insbesondere von Freileitungen, die beispielsweise mittels Isolatoren an Traversen aufgehängt sind, einen Spannungs-prüfer zu schaffen, der wegen seiner relativ kleinen Abmessung auch unter ungünstigen Bedingungen ohne Schwierigkeiten zu handhaben ist, wobei trotz eines vereinfachten Aufbaus Störeinflüsse zuverlässig ausgeschaltet werden können, wird erfindungsgemäß ein kapazitiver Spannungsprüfer 1 angegeben, wie er schematisch in FIG. 1 dargestellt ist.

Kurz zusammengefasst weist der kapazitive Spannungsprüfer 1 eine Kontaktelektrode 2 auf, welche dazu ausgebildet ist, bedarfsweise mit der zu prüfenden elektrischen Leitung 100 einen galvanischen Kontakt auszubilden.

Der kapazitive Spannungsprüfer 1 gemäß der vorliegenden Erfindung weist ferner eine Prüfeinrichtung 3 auf mit einer in einem Messbereich 4 angeordneten Sensoreinrichtung zum Erfassen eines elektrischen Feldes in dem Messbereich 4.

Schließlich weist der kapazitive Spannungsprüfer 1 noch eine mit der Sensoreinrichtung signaltechnisch und insbesondere galvanisch verbundene Auswerteelektronik 5 auf.

Erfindungsgemäß ist in diesem Zusammenhang insbesondere vorgesehen, dass die Prüfeinrichtung 3 eine Abschirmeinrichtung 6 aufweist, welche dazu ausge-bildet ist, in Abhängigkeit von einer an der zu prüfenden elektrischen Leitung 100 anliegenden Nennspannung von beispielsweise 30 kV in dem Messbereich 4 ein von der Sensoreinrichtung als Messfeld zu erfassendes homogenes elektrisches Feld zu generieren. Zusätzlich ist die Abschirmeinrichtung 6 dazu ausgebildet, das Messfeld vor externen Störfeldern abzuschirmen.

Wie es insbesondere der schematischen Darstellung in FIG. 1 entnommen werden kann, ist gemäß der exemplarischen Ausführungsform des erfindungsgemäßen Spannungsprüfers 1 vorgesehen, dass die Abschirmeinrichtung 6 eine erste Elektrode 6.1 (Schirmelektrode) und eine von der ersten Elektrode 6.1 beabstandete, zweite Elektrode 6.2 (Referenzelektrode) aufweist, wobei der Messbereich 4 in einem Bereich zwischen der ersten Elektrode 6.1 und der zweiten Elektrode 6.2 ausgebildet ist.

Dabei ist insbesondere vorgesehen, dass die erste Elektrode 6.1 (Schirm-elektrode) über die Kontaktelektrode 2 mit der zu prüfenden elektrischen Leitung 100 verbunden oder verbindbar ist. Andererseits ist die zweite Elektrode 6.2 (Referenzelektrode) mit einem Referenzpotenzial und insbesondere mit dem Erd-Potenzial insbesondere kapazitiv verbunden oder verbindbar.

Die Funktion des erfindungsgemäßen kapazitiven Spannungsprüfers 1 beruht auf dem Strom durch die Streukapazität zum Erd-Potenzial. Der Spannungsprüfer 1 stellt einen Strompfad von dem zu prüfenden Anlageteil (Leiter 100) zum Erd-Potenzial her. Von der Kontaktelektrode 2 des Spannungsprüfers 1 fließt der Strom über eine Hochimpedanz-Kette zu einer Anzeigeeinheit des Spannungsprüfers 1.

Zwischen der Anzeigeeinheit und dem Erd-Potenzial entsteht durch die Luft als Dielektrikum ein Kondensator. Da ein Kondensator Wechselstrom leiten kann, fließt ein Strom im Mikroampere-Bereich von der Anzeigeeinheit durch die Luft zum Erd-Potenzial.

Insbesondere fließt bei dem erfindungsgemäßen kapazitiven Spannungsprüfer 1 kein Strom durch den Bediener bzw. Anwender des Spannungsprüfers 1. Das Ergebnis der Spannungsprüfung ist daher unabhängig von einer möglichen Standortisolation oder einer persönlichen Schutzausrüstung des Anwenders bzw. Bedieners des Spannungsprüfers 1.

Problematisch sind bei diesem Funktionsprinzip die so genannten Störfelder. Hierbei handelt es sich um ein überlagerndes elektrisches Feld, das die Anzeige des Spannungsprüfers 1 beeinflussen kann. Dieses überlagernde Störfeld kann von dem zu prüfenden oder anderen, benachbarten Anlageteilen herrühren und eine beliebige Phasenlage haben. Es kann daher in unerwünschter Weise zu verfälschten Mess-/Prüfergebnissen des Spannungsprüfers 1 kommen.

Problematisch ist außerdem die Frequenzabhängigkeit. Bei der Frequenz von 16,7 Hz ist beispielsweise das Signal dreimal schwächer als bei 50 Hz.

Das Funktionsprinzip des erfindungsgemäßen Spannungsprüfers 1, dessen Aufbau schematisch in FIG. 1 dargestellt ist, beruht auf der Messung der Spannung in einem homogenen elektrischen Feld, dem so genannten Messfeld, zwischen der ersten Elektrode 6.1 (Schirmelektrode) und der Referenzelektrode (zweiten Elektrode 6.2). Die Auswerteelektronik 5 befindet sich, wie in FIG. 1 schematisch dargestellt, hinter der Referenzelektrode (zweiten Elektrode 6.2). Dadurch ist die Auswerteelektronik 5 gegenüber Einflüssen jeglicher externer Störfelder geschützt. Schutzmaßnahmen, wie beispielsweise ein Faradayscher Käfig, sind nicht notwendig.

Der Aufbau des erfindungsgemäßen Spannungsprüfers 1 eignet sich insbesondere für Nennspannungen bis 420 kV.

Die Auswerteelektronik 5 des Spannungsprüfers 1 misst den Potenzialunterschied im Messfeld über mindestens einen Feldsensor 7.1, 7.2.

Die Schirmelektrode (erste Elektrode 6.1) ist mit dem zu prüfenden Leiter 100 galvanisch verbunden und hat dadurch ein proportionales elektrisches Potenzial zu dem des zu prüfenden Leiters 100.

Insbesondere ist erfindungsgemäß vorgesehen, dass die erste Elektrode 6.1 und die zweite Elektrode 6.2 einen bestimmten Mindestradius (R) aufweisen. Dadurch wird der Aufbau eines homogenen elektrischen Felds (Messfelds) sichergestellt.

Der Mindestradius der ersten und der zweiten Elektrode 6.1, 6.2 wird vorzugsweise abgeleitet aus dem Verfahren nach Helmholtz (Helmholtz-Spule). Demnach muss der Radius (R) der Elektroden 6.1 und 6.2 gleich groß sein wie der Abstand zwischen den Elektroden 6.1 und 6.2. Vorzugsweise beträgt der Radius etwa 30 mm.

Neben dem Aufbau des homogenen Messfelds haben die erste Elektrode 6.1 und die zweite Elektrode 6.2 zusätzlich die Aufgabe, das Messfeld vor externen Störfeldern abzuschirmen.

Die Kombination aus homogenem Messfeld und Abschirmung durch die erste Elektrode 6.1 und die zweite Elektrode 6.2 wirkt sich sehr positiv auf das Messergebnis aus. Insbesondere wurde festgestellt, dass die Stärke und Homogenität des Feldgradienten im Bereich 0 bis 60 Hz frequenzunabhängig ist.

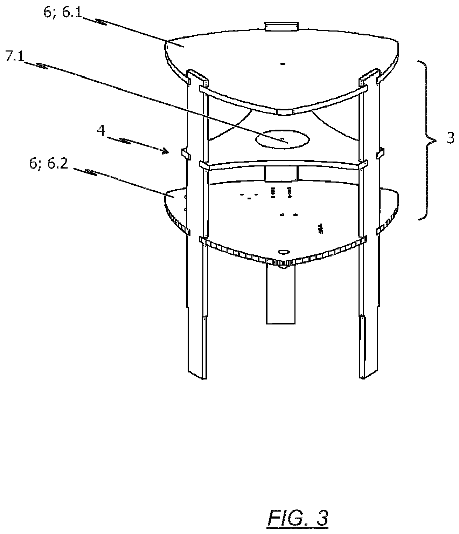

Demnach ist gemäß bevorzugten Realisierungen des erfindungsgemäßen Spannungsprüfers 1 vorgesehen, dass die erste Elektrode 6.1 (Schirmelektrode) eine mit Bezug auf eine senkrechte Ausrichtung zu den Feldlinien des Messfelds ausgerichtete Elektrodenfläche mit einem ersten, insbesondere effektiven Durchmesser aufweist, wobei die zweite Elektrode 6.2 einen mit Bezug auf eine senkrechte Ausrichtung zu den Feldlinien des Messfelds ausgerichtete Elektrodenfläche mit einem zweiten, insbesondere effektiven Durchmesser aufweist, wobei vorzugsweise der erste Durchmesser zumindest im Wesentlichen gleich groß wie der zweite Durchmesser ist. In diesem Zusammenhang wird beispielsweise auch auf die isometrische Darstellung in FIG. 3 verwiesen.

Um eine möglichst effiziente Abschirmung erreichen zu können, sollte der Abstand der Elektrodenfläche der ersten Elektrode 6.1 von der Elektrodenfläche der zweiten Elektrode 6.2 dem 0,3-fachen bis 0,7-fachen und vorzugsweise dem 0,4-fachen bis 0,6-fachen und noch bevorzugter etwa dem 0,5-fachen des ersten und/oder zweiten Durchmessers der Elektrodenfläche der ersten und/oder zweiten Elektrode 6.1, 6.2 entsprechen.

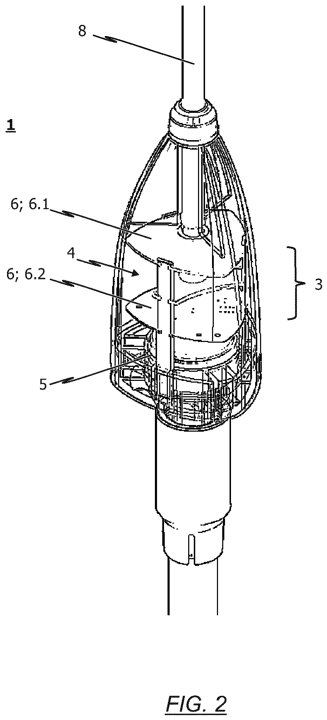

Wie es der isometrischen und teiltransparenten Darstellung in FIG. 2 entnommen werden kann, weist bei der exemplarischen Ausführungsform des erfindungsgemäßen Spannungsprüfers 1 die zweite Elektrode 6.2 eine in Richtung der ersten Elektrode 6.1 ausgerichtete erste Fläche und eine gegenüberliegende zweite Fläche auf, wobei die Auswerteelektronik 5 zumindest bereichsweise hinter der zweiten Fläche der zweiten Elektrode 6.2 angeordnet ist.

Die in dem Messbereich 4 angeordnete Sensoreinrichtung weist vorzugsweise einen ersten Feldsensor 7.1 und optional einen in Richtung der Feldlinien des elektrischen Felds von dem ersten Feldsensor 7.1 beabstandeten, zweiten Feldsensor 7.2 auf. Wesentlich in diesem Zusammenhang ist jedoch, dass die Sensoreinrichtung dazu ausgebildet ist, mit Hilfe des mindestens einen Feldsensors 7.1, 7.2 einen Potenzialunterschied in dem elektrischen Feld zu erfassen.

Wie es den Darstellungen in FIG. 2 und FIG. 3 entnommen werden kann, weist der mindestens eine Feldsensor 7.1, 7.2 eine vorzugsweise abgerundete oder runde Feldsonde mit einem Radius von 4 mm bis 15 mm und vorzugsweise mit einem Radius von 6 mm bis 13 mm und noch bevorzugter mit einem Radius von etwa 8 mm bis 11 mm auf, wobei der Abstand der Elektrodenfläche der ersten Elektrode 6.1 von der Elektrodenfläche der zweiten Elektrode 6.2 einen Wert von 30 mm bis 80 mm und vorzugsweise von 40 mm bis 70 mm besitzt.

Den Darstellungen in FIG. 1 und FIG. 2 ist ferner zu entnehmen, dass die Kontaktelektrode 2 des erfindungsgemäßen Spannungsprüfers 1 vorzugsweise über eine Kontaktelektrodenverlängerung 8 galvanisch mit der zu prüfenden elektrischen Leitung 100 verbunden oder verbindbar ist. Insbesondere weist die Kontaktelektrodenverlängerung 8 mindestens einen vorab festgelegten oder festlegbaren elektrischen Widerstand, insbesondere in Gestalt einer Impedanz-Kette, auf.

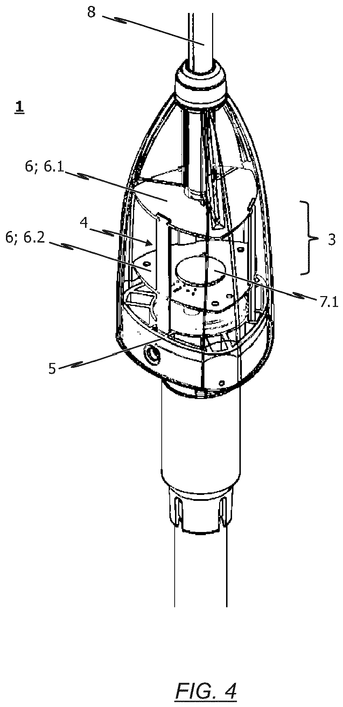

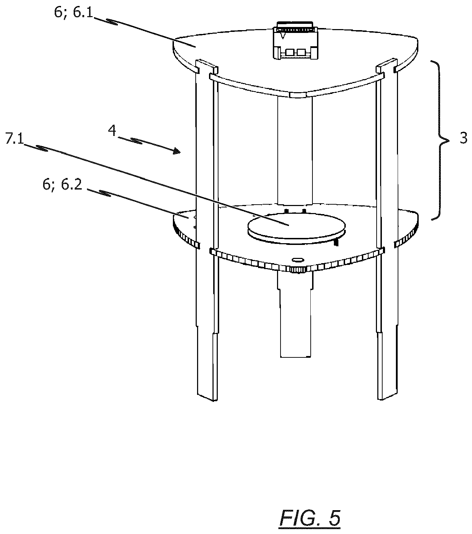

Nachfolgend wird unter Bezugnahme auf FIG. 4 und FIG. 5 eine weitere exemplarische Ausführungsform des erfindungsgemäßen Spannungsprüfers 1 beschrieben.

Wie es der isometrischen und teiltransparenten Darstellung in FIG. 4 entnommen werden kann, weist die zweite Elektrode 6.2 eine in Richtung der ersten Elektrode 6.1 ausgerichtete erste Fläche und eine gegenüberliegende zweite Fläche auf, wobei die Auswerteelektronik 5 zumindest bereichsweise hinter der zweiten Fläche der zweiten Elektrode 6.2 angeordnet ist. Zumindest bereichsweise ist zwischen der ersten Elektrode 6.1 der Abschirmeinrichtung 6 und der zweiten Elektrode 6.2 der Abschirmeinrichtung 6 der Messbereich 4 des Spannungsprüfers 1 gebildet.

Insbesondere ist in diesem Zusammenhang vorgesehen, dass die in dem Messbereich 4 angeordnete Sensoreinrichtung einen ersten Feldsensor 7.1 aufweist und dazu ausgebildet ist, mit Hilfe des Feldsensors 7.1 einen Potenzialunterschied in dem elektrischen Feld zu erfassen.

In diesem Zusammenhang ist bevorzugt, dass der Feldsensor 7.1 eine vorzugsweise abgerundete oder runde Feldsonde mit einem Radius von 4 mm bis 15 mm und vorzugsweise mit einem Radius von 6 mm bis 13 mm und noch bevorzugter mit einem Radius von etwa 8 mm bis 11 mm aufweist.

Andererseits ist es bevorzugt, dass der Abstand der Elektrodenfläche der ersten Elektrode 6.1 der Abschirmeinrichtung 6 von der Elektrodenfläche der zweiten Elektrode 6.2 der Abschirmeinrichtung 6 einen Wert von 30 mm bis 80 mm und vorzugsweise von 40 mm bis 70 mm aufweist.

Die Sensoreinrichtung weist den bereits genannten ersten Feldsensor 7.1 auf, der zumindest bereichsweise in dem Messbereich 4 angeordnet ist. Mit Hilfe des Feldsensors 7.1 ist ein Potenzialunterschied in dem elektrischen Feld in dem Messbereich 4 erfassbar.

Im Unterschied zu der in FIG. 2 und FIG. 3 gezeigten Ausführungsform des erfindungsgemäßen Spannungsprüfers 1 ist bei der in FIG. 4 und FIG. 5 gezeigten Ausführungsform vorgesehen, dass in dem Messbereich 4 der Feldsensor 7.1 der Sensoreinrichtung an oder in unmittelbarer Nähe der zweiten Elektrode 6.2 der Abschirmeinrichtung 6 angeordnet ist. Insbesondere beträgt ein Abstand zwischen einem Sensorbereich des Feldsensors 7.1 der Sensoreinrichtung und der zweiten Elektrode 6.2 der Abschirmeinrichtung 6 vorzugsweise maximal 5 mm und vorzugsweise insbesondere maximal 2 mm beträgt.

Die Erfindung ist nicht auf die in den Zeichnungen gezeigten Ausführungsformen beschränkt, sondern ergibt sich aus einer Zusammenschau sämtlicher hier offenbarter Merkmale.

Insbesondere ist es in diesem Zusammenhang denkbar, dass der Spannungs-prüfer 1 eine Eigenprüfvorrichtung aufweist zum bedarfsweisen Prüfen der Funktion des Spannungsprüfers 1.

In diesem Zusammenhang ist es beispielsweise denkbar, dass die erste Elektrode 6.1 und die von der ersten Elektrode 6.1 beabstandete, zweite Elektrode 6.2 der Abschirmeinrichtung 6 einen Kondensator bilden, wobei die Prüfvorrichtung dazu ausgebildet ist, die Kapazität des von der ersten Elektrode 6.1 und der zweiten Elektrode 6.2 gebildeten Kondensators zu messen.

Alternativ oder zusätzlich ist es denkbar, dass die Eigenprüfvorrichtung dazu ausgebildet ist, vorzugsweise über eine Messung der Kapazität des von der ersten Elektrode 6.1 und der zweiten Elektrode 6.2 gebildeten Kondensators zu prüfen,
(i) ob ein durchgehender galvanischer Kontakt zwischen der Kontaktelektrode 2 und dem Kondensator existiert; und/oder
(ii) ob die Signal-Integrität gegeben ist, das heißt, ob ein Signal auf dem Weg von der Kontaktelektrode 2 zu der Auswerteelektronik 5 nicht verändert ist.

Ferner ist bei bevorzugten Realisierungen des erfindungsgemäßen Spannungsprüfers vorgesehen, dass die Abschirmeinrichtung 6 eine erste Elektrode 6.1 und eine von der ersten Elektrode 6.1 beabstandete, zweite Elektrode 6.2 aufweist, wobei die Elektrodenfläche der ersten Elektrode 6.1 und die Elektrodenfläche der zweiten Elektrode 6.2 vorzugsweise zumindest im Wesentlichen die gleiche Formgebung aufweisen.

Herbei bietet es sich an, dass die Elektrodenfläche der ersten Elektrode 6.1 und/oder die Elektrodenfläche der zweiten Elektrode 6.2 die Form eines Gleichdickes, und insbesondere die Form eines Reuleaux-Dreieckes aufweisen/aufweist.

## Patentansprüche

1. Kapazitiver Spannungsprüfer (1), insbesondere für eine oberirdische elektrische Leitung (100), wobei der Spannungsprüfer (1) Folgendes aufweist:
- eine Kontaktelektrode (2), welche dazu ausgebildet ist, bedarfsweise mit der zu prüfenden elektrischen Leitung (100) einen galvanischen Kontakt auszubilden;
- eine Prüfeinrichtung (3) mit einer in einem Messbereich (4) angeordneten Sensoreinrichtung (7.1, 7.2) zum Erfassen eines elektrischen Felds in dem Messbereich (4); und
- eine mit der Sensoreinrichtung (7.1, 7.2) signaltechnisch und insbesondere galvanisch verbundene Auswerteelektronik (5),
wobei die Prüfeinrichtung (3) eine Abschirmeinrichtung (6) aufweist, welche dazu ausgebildet ist, in Abhängigkeit von einer an der zu prüfenden elektrischen Leitung (100) anliegenden Nennspannung in dem Messbereich (4) ein von der Sensoreinrichtung (7.1, 7.2) als Messfeld zu erfassendes homogenes elektrisches Feld zu generieren, und welche ferner dazu ausgebildet ist, das Messfeld vor externen Störfeldern abzuschirmen.

2. Spannungsprüfer (1) nach Anspruch 1,
wobei die Abschirmeinrichtung (6) eine erste Elektrode (6.1) und eine von der ersten Elektrode (6.1) beabstandete, zweite Elektrode (6.2) aufweist, wobei der Messbereich (4) in einem Bereich zwischen der ersten und der zweiten Elektrode (6.1, 6.2) ausgebildet ist, wobei die erste Elektrode (6.1) über die Kontaktelektrode (2) galvanisch mit der zu prüfenden elektrischen Leitung (100) verbunden oder verbindbar ist, und wobei die zweite Elektrode (6.2) mit einem Referenzpotenzial, insbesondere mit dem Erd-Potenzial, galvanisch verbunden oder verbindbar ist.

3. Spannungsprüfer (1) nach Anspruch 2,
wobei die erste Elektrode (6.1) eine mit Bezug auf eine senkrechte Ausrichtung zu den Feldlinien des Messfelds ausgerichtete Elektrodenflächen mit einem ersten insbesondere effektiven Durchmesser aufweist, und wobei die zweite Elektrode (6.2) eine mit Bezug auf eine senkrechte Ausrichtung zu den Feldlinien des Messfelds ausgerichtete Elektrodenfläche mit einem zweiten insbesondere effektiven Durchmesser aufweist, wobei vorzugsweise der erste Durchmesser zumindest im Wesentlichen gleich groß wie der zweite Durchmesser ist.

4. Spannungsprüfer (1) nach Anspruch 3,
wobei ein Abstand der Elektrodenfläche der ersten Elektrode (6.1) von der Elektrodenfläche der zweiten Elektrode (6.2) dem 0,3-fachen bis 0,7-fachen und vorzugsweise dem 0,4-fachen bis 0,6-fachen und noch bevorzugter etwa dem 0,5-fachen des ersten und/oder zweiten Durchmessers der Elektrodenfläche der ersten und/oder zweiten Elektrode (6.1, 6.2) entspricht.

5. Spannungsprüfer (1) nach Anspruch 3 oder 4,
wobei der Abstand der Elektrodenfläche der ersten Elektrode (6.1) der Abschirmeinrichtung (6) von der Elektrodenfläche der zweiten Elektrode (6.2) der Abschirmeinrichtung (6) einen Wert von 10 mm bis 100 mm und vorzugsweise 20mm bis 80 mm und noch bevorzugter 30 mm bis 70 mm besitzt.

6. Spannungsprüfer (1) nach einem der Ansprüche 2 bis 5,
wobei die zweite Elektrode (6.2) der Abschirmeinrichtung (6) eine in Richtung der ersten Elektrode (6.1) der Abschirmeinrichtung (6) ausgerichtete erste Fläche und eine gegenüberliegende zweite Fläche aufweist, wobei die Auswerteelektronik (5) zumindest bereichsweise hinter der zweiten Fläche der zweiten Elektrode (6.2) der Abschirmeinrichtung (6) angeordnet ist.

7. Spannungsprüfer (1) nach einem der Ansprüche 1 bis 6,
wobei die Auswerteelektronik (5) einen Mikrocontroller mit einem Operationsverstärker, einem Komparator und einem D/A-Wandler aufweist und dazu ausgebildet ist, einen von mindestens einem Feldsensor (7.1, 7.2) in dem Messfeld erfassten Potenzialunterschied auszuwerten, wobei der Spannungsprüfer (1) ferner ein Anzeigegerät aufweist, welches von der Auswerteelektronik (5) ansteuerbar und dazu ausgebildet ist, in Abhängigkeit von dem von dem mindestens einen Feldsensor (7.1, 7.2) in dem Messfeld erfassten Potenzialunterschied das Vorhandensein oder das Nichtvorhandensein von Betriebsspannung an der Kontaktelektrode (2) anzuzeigen.

8. Spannungsprüfer (1) nach einem der Ansprüche 1 bis 7,
wobei die in dem Messbereich (4) angeordnete Sensoreinrichtung einen ersten Feldsensor (7.1) und optional einen in Richtung der Feldlinien des elektrischen Felds von dem ersten Feldsensor (7.1) beabstandeten, zweiten Feldsensor (7.2) aufweist und dazu ausgebildet ist, mit Hilfe des mindestens einen Feldsensors (7.1, 7.2) einen Potenzialunterschied in dem elektrischen Feld zu erfassen.

9. Spannungsprüfer (1) nach Anspruch 8,
wobei die Abschirmeinrichtung (6) eine erste Elektrode (6.1) und eine von der ersten Elektrode (6.1) beabstandete, zweite Elektrode (6.2) aufweist, wobei der mindestens eine Feldsensor (7.1, 7.2) eine vorzugsweise abgerundete oder runde Feldsonde mit einem Radius von 4 mm bis 15 mm und vorzugsweise mit einem Radius von 6 mm bis 13 mm und noch bevorzugter mit einem Radius von etwa 8 mm bis 11 mm aufweist, und wobei der Abstand der Elektrodenfläche der ersten Elektrode (6.1) der Abschirmeinrichtung (6) von der Elektrodenfläche der zweiten Elektrode (6.2) der Abschirmeinrichtung (6) einen Wert von 30 mm bis 80 mm und vorzugsweise 40 mm bis 70 mm aufweist.

10. Spannungsprüfer (1) nach Anspruch 8 oder 9,
wobei zumindest bereichsweise zwischen der ersten Elektrode (6.1) der Abschirmeinrichtung (6) und der zweiten Elektrode (6.2) der Abschirmeinrichtung (6) der Messbereich (4) gebildet ist, wobei die Sensoreinrichtung einen zumindest bereichsweise in dem Messbereich (4) angeordneten ersten Feldsensor (7.1) und optional einen in Richtung der Feldlinien des elektrischen Felds von dem ersten Feldsensor (7.1) beabstandeten und zumindest bereichsweise in dem Messbereich (4) angeordneten zweiten Feldsensor (7.2) aufweist und dazu ausgebildet ist, mit Hilfe des mindestens einen Feldsensors (7.1, 7.2) einen Potenzialunterschied in dem elektrischen Feld in dem Messbereich (4) zu erfassen.

11. Spannungsprüfer (1) nach Anspruch 10,
wobei in dem Messbereich (4) der ersten Feldsensor (7.1) der Sensoreinrichtung an oder in unmittelbarer Nähe der ersten Elektrode (6.1) der Abschirmeinrichtung (6) oder der zweiten Elektrode (6.2) der Abschirmeinrichtung (6) angeordnet ist, wobei der Abstand zwischen einem Sensorbereich des ersten Feldsensors (7.1) der Sensoreinrichtung und der ersten Elektrode (6.1) der Abschirmeinrichtung (6) oder der zweiten Elektrode (6.2) der Abschirmeinrichtung (6) vorzugsweise maximal 5 mm und vorzugsweise insbesondere maximal 2 mm beträgt.

12. Spannungsprüfer (1) nach einem der Ansprüche 1 bis 11,
wobei die Abschirmeinrichtung (6) eine erste Elektrode (6.1) und eine von der ersten Elektrode (6.1) beabstandete, zweite Elektrode (6.2) aufweist, wobei die Elektrodenfläche der ersten Elektrode (6.1) und die Elektrodenfläche der zweiten Elektrode (6.2) vorzugsweise zumindest im Wesentlichen die gleiche Formgebung aufweisen.

13. Spannungsprüfer (1) nach Anspruch 12,
wobei die Elektrodenfläche der ersten Elektrode (6.1) und/oder die Elektrodenfläche der zweiten Elektrode (6.2) die Form eines Gleichdickes, und insbesondere die Form eines Reuleaux-Dreieckes aufweisen/aufweist.

14. Spannungsprüfer (1) nach einem der Ansprüche 1 bis 13,
wobei die Kontaktelektrode (2) vorzugsweise über eine Kontaktelektrodenverlängerung (8) galvanisch mit der zu prüfenden elektrischen Leitung (100) verbunden oder verbindbar ist, wobei die Kontaktelektrodenverlängerung (8) mindestens einen vorab festgelegten oder festlegbaren elektrischen Widerstand, insbesondere in Gestalt einer Widerstandskette, aufweist.

15. Spannungsprüfer (1) nach einem der Ansprüche 1 bis 14,
wobei der Spannungsprüfer (1) eine Eigenprüfvorrichtung aufweist zum bedarfsweisen Prüfen der Funktion des Spannungsprüfers (1).

16. Spannungsprüfer (1) nach Anspruch 15 und Anspruch 2,
wobei die erste Elektrode (6.1) und die von der ersten Elektrode (6.1) beabstandete, zweite Elektrode (6.2) der Abschirmeinrichtung (6) einen Kondensator bilden, und wobei die Eigenprüfvorrichtung dazu ausgebildet ist, eine Kapazität des von der ersten und der zweiten Elektrode (6.1, 6.2) gebildeten Kondensators zu messen.

17. Spannungsprüfer (1) nach Anspruch 15 oder 16,
wobei die Eigenprüfvorrichtung dazu ausgebildet ist, vorzugsweise über eine Messung der Kapazität des von der ersten und der zweiten Elektrode (6.1, 6.2) gebildeten Kondensators zu prüfen, ob ein durchgehender galvanischer Kontakt zwischen der Kontaktelektrode (2) und dem Kondensator existiert und/oder ob die Signal-Integrität gegeben ist und ein Signal auf dem Weg der Kontaktelektrode (2) zu der Auswerteelektronik (5) nicht verändert ist.

18. Spannungsprüfer (1) nach einem der Ansprüche 1 bis 17,
wobei die signaltechnische Verbindung zwischen der Kontaktelektrode (2) und der ersten Elektrode (6.1) kapazitiv, induktiv und/oder galvanisch ausgebildet ist.
